# EUROPEAN PATENT APPLICATION

(11) **EP 4 641 617 A1**
(43) Date of publication of application: **29.10.2025**
(21) Application number: 24884038.1
(22) Date of filing: 17.07.2024
(51) Int. Cl.: H01L 21/02

(54) **CRYOGENIC PEELING METHOD FOR WAFTER**

(30) Priority: 02.11.2023 CN 202311190662
(71) Applicant: Westlake Instruments (Hangzhou) Technology Co., Ltd., Hangzhou, Zhejiang 310024 (CN)
(72) Inventor: LIU, Dongli, Hangzhou, Zhejiang 310024 (CN); LIU, Xiao, Hangzhou, Zhejiang 310024 (CN); YU, Xiaoying, Hangzhou, Zhejiang 310024 (CN)
(74) Representative: Bayramoglu et al.
(86) International application number: PCT/CN2024/105854
(87) International publication number: WO 2025/092030

(57) **Abstract**

The invention relates to a wafer cryo-peeling method, which includes the following steps: coating a liquid water-soluble medium on an end surface of an ingot and/or a clamping surface of a temperature-controlled clamp, and cooling and solidifying the water-soluble medium under the action of the temperature-controlled clamp to complete fixing of the ingot between a pair of temperature-controlled clamps; and moving at least one temperature-controlled clamp until a modified layer of the ingot is separated, and after peeling is completed, heating and liquefying the solid water-soluble medium under the action of the temperature-controlled clamp to obtain a wafer and remaining ingot. The method has the advantages of high peeling efficiency, saved cleaning process, easy control of peeling conditions, low risk of cracking, simple operation, and suitability for large-scale industrial applications.

## Description

### TECHNICAL FIELD

The present invention relates to the technical field of wafer processing, and in particular, to a wafer cryo-peeling method.

### BACKGROUND

At present, the most advanced chip manufacturing processes require nearly 4,000 steps. Broadly categorized, these steps mainly include wafer processing (raw materials-ingot-wafer), wafer fabrication (front-end process), including deposition, lithography, etching, ion implantation, and metallization and the like, and packaging testing (back-end process), including cutting, die attachment, bonding and the like. The laser mainly provides new process solutions for wafer processing and packaging testing by virtue of the applicability of the laser in the aspects of cutting, drilling, welding and the like.

In the field of wafer processing, lasers can cut ingots into wafers after the ingots have been grown and shaped. As an alternative to the current slurry wire sawing or diamond wire sawing methods, laser slicing has a higher precision and efficiency, with less impact on and loss of material. Therefore, the laser slicing is more suitable for cutting high-hardness, high-brittleness materials such as SiC wafers (third-generation semiconductors). Currently, after laser processing and modification below a surface of an ingot, wafers are peeled from the ingot by means of external force. Compared with traditional wire sawing methods, laser slicing has the advantages of higher efficiency and lower material loss. However, a reliable peeling method is required to ensure the success rate and efficiency of wafer peeling. Additionally, the cleaning process following peeling must be simple and effective to remove contamination from the previous process and prepare for the next process.

Chinese Patent with Publication No. CN115410979B, previously applied for by the applicant, discloses a wafer peeling method. For a wafer modified by laser processing, a to-be-peeled sample is bonded with a hot melt adhesive and then the wafer is peeled. In addition, Chinese Patent with Publication No. CN113972160A discloses a laser slicing method for a solid material. According to the method, a peeling surface is formed inside the solid material with laser; and a thin-layer wafer is obtained by preheating thermoplastic glue to the glass transition temperature, coating the thermoplastic glue on a surface of a solid material in a heating state, and then naturally cooling stress cracks generated by the difference of the thermal expansion coefficients. The thermoplastic glue or hot melt adhesive used in the above method may leave adhesive residue on the surface of the peeled wafer, which needs to be cleaned in another process, so that the wafer cannot be directly subjected to the thinning and polishing process.

Chinese Patent with Publication No. CN115138987A discloses a silicon carbide wafer peeling method, in which a thick layer and a thin layer of silicon carbide modified by laser processing are heated and cooled, so that a temperature difference is formed between the thin layer and the thick layer, thereby destroying the physical connection between the thin layer and the thick layer, and then peeling off the thick layer and the thin layer. Meanwhile, Chinese Patent with Publication No. CN115513043A discloses a method for peeling a wafer from a silicon carbide ingot, in which a liquid prepared in advance is injected into a modified layer of the silicon carbide ingot by ultrasonic vibration, and after the modified layer is filled with the liquid, the silicon carbide ingot filled with the liquid is cooled until the liquid freezes, causing the modified layer to expand and break, and the wafer layer is peeled off from the silicon carbide substrate. In the above method, due to the high thermal conductivity of silicon carbide material, it is difficult to form a relatively large temperature difference on two sides of silicon carbide to achieve peeling. In addition, in the solution of injecting liquid into the modified layer for cooling, the liquid can only penetrate into cracks generated by laser processing, but cannot penetrate into a laser processing trace area, there will be uneven force during cooling and expansion, and silicon carbide wafer is at a greater risk of breakage as the hard and brittle material, and this solution is difficult to implement in an automated production line.

Chinese Patent with Publication No. CN111106032A discloses a chip generating device. This device positions a focal point of a laser beam with a wavelength that is transmissive to an ingot at a depth from an upper surface of the ingot equivalent to a thickness of a chip to be generated, and irradiates the ingot with laser beam to form a peeling layer; and then the chip is peeled off from the ingot by a chip peeling unit. According to the above method, the upper surface of the ingot is adsorbed by an adsorption sheet, and an entire ingot is placed in a liquid environment, ultrasonic action is applied to reduce the strength of the peeling layer, and then the adsorption sheet is controlled to rise by the cylinder to peel off the chip. When ultrasound is applied by the above device, if the cracks inside the peeling layer are not uniform and smooth enough, the ultrasound time needs to be extended. There is a lack of standards for evaluating whether the peeling strength is lower than an adsorption force of a suction cup. In addition, it is difficult to peel when the ultrasound fails to reduce the peeling layer strength to below the adsorption force of the suction cup. Moreover, the device is increased in complexity and the risk of liquid leakage is caused by applying the ultrasonic action in a liquid environment.

In summary, in the conventional wafer peeling process, mechanical stretching peeling, bonding or adsorption fixing of the wafer for auxiliary peeling, damage of physical connection of the modified layer by temperature difference or liquid cooling expansion, and ultrasonic-assisted reduction of strength of the peeled layer are generally adopted, so that peeling of the thin-layer wafer on the ingot is completed. However, these methods have problems such as low peeling efficiency, complex back-end cleaning process, difficult to control peeling conditions, high risk of cracking, and complex equipment, which are not suitable for large-scale industrial applications and need to be improved.

### SUMMARY

In view of the defects of the prior art, the present invention provides a wafer cryo-peeling method, which has the advantages of high peeling efficiency, saved cleaning process, easy control of peeling conditions, low risk of cracking, simple operation, and suitability for large-scale industrial applications.

The objective of the present invention is achieved by the following technical solutions:
A wafer cryo-peeling method includes the following steps:
S1. coating a liquid water-soluble medium on an end surface of an ingot and/or a clamping surface of a temperature-controlled clamp, and cooling and solidifying the water-soluble medium under the action of the temperature-controlled clamp to complete fixing of the ingot between a pair of temperature-controlled clamps; and
S2. moving at least one temperature-controlled clamp until a modified layer of the ingot is separated, and after peeling is completed, heating and liquefying the solid water-soluble medium under the action of the temperature-controlled clamp to obtain a wafer and remaining ingot.

Further, in the S1, the water-soluble medium is one or a combination of water, a water-soluble organic compound, and a water-soluble inorganic compound. The combination is specifically a combination of at least two water-soluble organic compounds, a combination of at least two water-soluble inorganic compounds, a combination of water and a plurality of water-soluble organic compounds, a combination of water and a plurality of water-soluble inorganic compounds, a combination of a plurality of water-soluble organic compounds and a plurality of water-soluble inorganic compounds, or a combination of water, a plurality of water-soluble organic compounds and a plurality of water-soluble inorganic compounds.

Furthermore, in the S1, a freezing point of the water-soluble medium is -50 °C to 80 °C, and a dynamic viscosity at room temperature and atmospheric pressure is 1.01×10⁻³-100 Pa·s.

Preferably, in the S1, the freezing point of the water-soluble medium is -50 °C, -40 °C, -30 °C, -20 °C, -10 °C, 0 °C, 10 °C, 20 °C, 30 °C, 40 °C, 50 °C, 60 °C, 70 °C or 80 °C, and the dynamic viscosity at room temperature and atmospheric pressure is 1.01×10⁻³ Pa·s, 0.01 Pa·s, 0.1 Pa·s, 1.0 Pa·s, 10 Pa·s, 20 Pa·s, 50 Pa·s, 80 Pa·s or 100 Pa·s.

Furthermore, in the S1, a volume concentration of each water-soluble organic compound and each water-soluble inorganic compound in the combination is 0.5-35% independently in the combination of water, a water-soluble organic compound and/or a water-soluble inorganic compound. The combination of water, a water-soluble organic compound and/or a water-soluble inorganic compound is specifically a combination of water and a plurality of water-soluble organic compounds, a combination of water and a plurality of water-soluble inorganic compounds, or a combination of water, a plurality of water-soluble organic compounds and a plurality of water-soluble inorganic compounds.

Preferably, in the S1, a volume concentration of each water-soluble organic compound and each water-soluble inorganic compound in the combination is 0.5%, 0.8%, 1.0%, 5%, 10%, 15%, 20%, 25%, 30% or 35% independently in the combination of the water, the water-soluble organic compound and/or the water-soluble inorganic compound.

Furthermore, in the S1, the water-soluble medium is one or a combination of water, a silane coupling agent, anionic polyacrylamide, cationic polyacrylamide, carboxymethyl cellulose and a surfactant.

Further, in the S1, the water-soluble medium is coated by dripping, spin coating, scraping, spraying, brushing, rolling, dipping, and transferring with an absorbent material having the water-soluble medium absorbed thereon. The water-soluble medium may be coated on an end surface of the ingot and/or a clamping surface of the temperature-controlled clamp by pumping and draining by a syringe pump/peristaltic pump and dripping onto the end surface of the ingot and/or the clamping surface of the temperature-controlled clamp, by directly coating the end surface of the ingot and/or the clamping surface of the temperature-controlled clamp by spin coating/scraping/spraying/brushing/rolling/dipping, and/or transferring and coating the end surface of the ingot and/or the clamping surface of the temperature-controlled clamp by means of an adsorbent material, and further by forcing the water-soluble medium to diffuse by applying pressure by the temperature-controlled clamp and evenly distributing between the end surface of the ingot and the clamping surface of the temperature-controlled clamp, or between the clamping surfaces of the pair of temperature-controlled clamps.

Further, in the S1, a pressure applied by the temperature-controlled clamp to the water-soluble medium during the cooling and solidification is controlled to be 1-3000 N, the cooling temperature is 1-40 °C lower than a freezing point of the water-soluble medium, the cooling time is 10-600 s, a use amount of the water-soluble medium is controlled to be 0.1-20 mL, and a thickness of the water-soluble medium after the cooling and solidification is controlled to be 20-200 µm.

Preferably, in the S1, the pressure applied by the temperature-controlled clamp to the water-soluble medium during the cooling and solidification is controlled to be 1 N, 10 N, 50 N, 100 N, 150 N, 200 N, 250 N, 300 N, 350 N, 400 N, 550 N, 600 N, 650 N, 700 N, 750 N, 800 N, 850 N, 900 N, 1000 N, 1100 N, 1200 N, 1300 N, 1400 N, 1500 N, 1600 N, 1700 N, 1800 N, 1900 N, 2000 N, 2100 N, 2200 N, 2300 N, 2400 N, 2500 N, 2600 N, 2700 N, 2800 N, 2900 N to 3000 N, the cooling temperature is 1 °C, 2 °C, 5 °C, 8 °C, 10 °C, 15 °C, 20 °C, 25 °C, 30 °C, 35 °C or 40 °C lower than a freezing point of the water-soluble medium, the cooling time is 10 s, 20 s, 30 s, 40 s, 50 s, 60 s, 70 s, 80 s, 90 s, 120 s, 150 s, 180 s, 210 s, 240 s, 270 s, 300 s, 330 s, 360 s, 390 s, 420 s, 450 s, 480 s, 510 s, 540 s, 570 s or 600 s, a use amount of the water-soluble medium is controlled to be 0.1 mL, 0.2 mL, 0.3 mL, 0.4 mL, 0.5 mL, 0.6 mL, 0.7 mL, 0.8 mL, 0.9 mL, 1.0 mL, 2 mL, 3 mL, 4 mL, 5 mL, 6 mL, 7 mL, 8 mL, 9 mL, 10 mL, 11 mL, 12 mL, 13 mL, 14 mL, 15 mL, 16 mL, 17 mL, 18 mL, 19 mL or 20 mL, and a thickness of the water-soluble medium after the cooling and solidification is controlled to be 20 µm, 30 µm, 40 µm, 50 µm, 60 µm, 70 µm, 80 µm, 90 µm, 100 µm, 110 µm, 120 µm, 130 µm, 140 µm, 150 µm, 160 µm, 170 µm, 180 µm, 190 µm or 200 µm. The use amount of water-soluble medium when a 4-inch ingot is peeled off is preferably 3.5 mL, and the use amount of water-soluble medium used when a 6-inch ingot is peeled off is preferably 8 mL.

Further, in the S2, a moving stretching speed of the temperature-controlled clamp is controlled to be 0.01-5.00 mm/min.

Further, the temperature-controlled clamp includes a heat-conducting clamp seat, a cooling and heating module arranged on the heat-conducting clamp seat, and a plurality of temperature detection modules, the cooling and heating module performs cooling or heating by diffusing from a central area to a peripheral area of the heat-conducting clamp seat, and the temperature detection modules are mounted on the heat-conducting clamp seat with detection ends facing a clamping surface and are arranged sequentially along a diffusion path of the cooling and heating module.

Furthermore, the temperature-controlled clamp further includes a plurality of injection channels formed on the heat-conducting clamp seat, wherein a liquid inlet of the injection channel is used to receive the water-soluble medium, and a liquid outlet is arranged on a clamping surface of the heat-conducting clamp seat.

Furthermore, the diffusion path of the cooling and heating module is one or a combination of a row-by-row diffusion path, a grid-interlaced diffusion path, a concentric circle diffusion path and a spiral line diffusion path.

Furthermore, the cooling and heating module includes a plurality of thermoelectric coolers arranged along a diffusion path. The thermoelectric cooler is a heat pump with the advantage of no sliding parts, which may be applied to occasions with limited space, high reliability requirement and no refrigerant pollution. According to the thermoelectric cooler, the Peltier effect of semiconductor materials is used. When direct current passes through a galvanic couple formed by two different semiconductor materials in series, heat may be absorbed and released at two ends of the galvanic couple, thereby achieving the purpose of cooling and heating. The thermoelectric cooler may be a square with a size ranging from 10 mm*10 mm to 60 mm*60 mm, and is evenly distributed horizontally on the heat-conducting clamp seat. To further improve the cooling effect of the thermoelectric cooler, at least two thermoelectric coolers may be arranged in a stacked manner.

Preferably, a water cooling block is arranged at one side of the thermoelectric cooler far away from the clamping surface of the heat-conducting clamp seat by conductive silver paste. The water-cooling block is a metal block made of copper or aluminum with water channels inside. To ensure the heat dissipation effect, a single water-cooling block is connected to a water-cooling machine by a liquid injection hole for cooling. This parallel connection method, compared with the series connection method of the water-cooling blocks, makes the water-cooling temperature of the thermoelectric cooler tend to be consistent, thereby ensuring the cooling effect.

Preferably, a heat dissipation channel is arranged at one side of the thermoelectric cooler away from the clamping surface of the heat-conducting clamp seat by heat-conducting silicone grease, and a flow path of a cooling medium in the heat dissipation channel passes through these thermoelectric coolers in sequence from the inside to the outside. The orthographic projection of the heat dissipation channel on the clamping surface of the heat-conducting clamp seat is in a spiral line shape, which ensures uniform heat dissipation of the thermoelectric cooler. The cooling medium of the heat dissipation channel is a coolant or cold air with a freezing point below -50 °C.

The cooling and heating module includes a liquid inlet arranged near the center of the heat-conducting clamp seat, a liquid outlet arranged near a periphery of the heat-conducting clamp seat, and a cold and hot medium channel arranged between the liquid inlet and the liquid outlet, and the orthographic projection of the cold and hot medium channel on the clamping surface of the heat-conducting clamp seat is in a spiral line shape.

Preferably, a heating medium of the cold and hot medium channels is a heating liquid or hot air with a boiling point above 100 °C, a purging medium of the cold and hot medium channels is compressed air, and a cooling medium of the cold and hot medium channels is a cooling liquid or cold air with a freezing point below -50 °C.

Furthermore, the temperature detection modules are temperature sensors, which are used to detect the temperature of each area from the central area to the peripheral area of the heat-conducting clamp seat, so as to control the temperature difference of the clamping surface of the temperature-controlled clamp within ±2 °C. The temperature sensor may be, for example, a contact temperature sensor, preferably a PT100 temperature sensor, and the PT100 temperature sensor is in contact with the inside of the temperature-controlled clamp seat through the heat-conducting silicone grease.

In summary, the beneficial technical effects of the present invention are:
1. According to the peeling method of the present invention, the water-soluble medium is cooled to a temperature below the freezing point by a temperature-controlled clamp, so that the freezing effect of cooling and solidification may be achieved, and the wafer may be directly stretched and peeled. After peeling, the water-soluble medium is reheated to a temperature above the freezing point, and the wafer may be quickly taken out. The surface of the wafer after peeling only needs to be simply purged to remove the water-soluble medium, and then the wafer is subjected to the next thinning process. The thinning process involves flushing, and the water-soluble medium dissolves and disappears during the flushing process. Compared with the gluing or waxing method, this peeling method saves the cleaning process and is more convenient to operate.
2. In the peeling process of the peeling method of the present invention, since the thermal conductivity of the wafer is generally good, the wafer to be peeled can be frozen by cooling one side directly. In addition, the water-soluble medium has good fluidity. The temperature-controlled clamp is pressed down on the surface of the wafer to force the water-soluble medium to be evenly distributed. The to-be-peeled surface and the surface of the temperature-controlled clamp are completely fitted, and the problem of uneven force causing fragmentation does not occur.
3. In the peeling process of the peeling method of the present invention, after the water-soluble medium is frozen, the bonding strength between the temperature-controlled clamp and the to-be-peeled wafer is far greater than the theoretical suction force (0.1 MPa) of a vacuum chuck, so that the separation of the wafer with a larger peeling force may be completed without a complicated auxiliary peeling device.

### BRIEF DESCRIPTION OF THE DRAWINGS

FIG. 1 is a schematic diagram of a connection relationship between a temperature-controlled clamp and an ingot according to Example 1 of the present invention.
FIG. 2 is a schematic structural diagram of a temperature-controlled clamp according to Example 2 of the present invention.
FIG. 3 is a schematic structural diagram of a temperature-controlled clamp according to Example 5 of the present invention.
FIG. 4 is a schematic structural diagram of a temperature-controlled clamp according to Example 6 of the present invention.

Reference numerals: 1. ingot; 11. wafer; 12. modified layer; 13. remaining ingot; 2. temperature-controlled clamp; 21. heat-conducting clamp seat; 22. cooling and heating module; 221. thermoelectric cooler; 222. liquid inlet; 223. liquid outlet; 224. cold and hot medium channel; 23. injection channel; 24. temperature detection module; 25. water-cooling block; 26. heat dissipation channel; and 3. water-soluble medium.

### DETAILED DESCRIPTION OF THE EMBODIMENTS

To make the technical means, creative features, objectives and functions achieved by the present invention clearer and easier to understand, the present invention is further explained below in conjunction with the accompanying drawings and specific implementations.

### Example

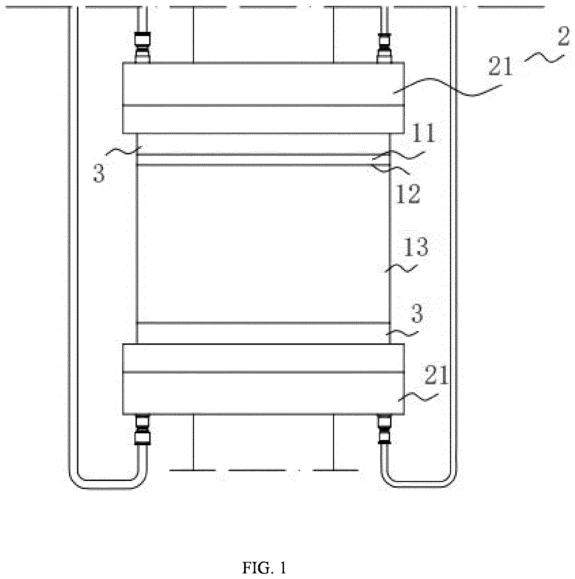

Example 1: Referring to FIG. 1, a cryo-peeling method for a wafer 11 disclosed in the present invention includes the following steps:
S1. coating a liquid water-soluble medium 3 on an end surface of an ingot 1 and/or a clamping surface of a temperature-controlled clamp 2, and cooling and solidifying the water-soluble medium 3 under the action of the temperature-controlled clamp 2 to complete fixing of the ingot 1 between a pair of temperature-controlled clamps 2; and
S2. moving at least one temperature-controlled clamp 2 until a modified layer 12 of the ingot is 1 separated, and after peeling is completed, heating and liquefying the solid water-soluble medium 3 under the action of the temperature-controlled clamp 2 to obtain a wafer 11 and remaining ingot 13.

Firstly, in the S1, the water-soluble medium 3 is one or a combination of water, a water-soluble organic compound and a water-soluble inorganic compound, a freezing point of the water-soluble medium 3 is -50 °C to 80 °C, and a dynamic viscosity at room temperature and atmospheric pressure is 1.01×10⁻³-100 Pa·s. To further improve the low-temperature freezing capacity of the water-soluble medium 3, a volume concentration of each water-soluble organic compound and each water-soluble inorganic compound in the combination is 0.5-35% independently in the combination of water, a water-soluble organic compound and/or a water-soluble inorganic compound, and the water-soluble medium 3 is one or a combination of water, a silane coupling agent, anionic polyacrylamide, cationic polyacrylamide, carboxymethyl cellulose and a surfactant.

Meanwhile, the water-soluble medium 3 is coated by dripping, spin coating, scraping, spraying, brushing, rolling, dipping, and transferring with an absorbent material having the water-soluble medium 3 absorbed thereon. The water-soluble medium 3 may be coated on an end surface of the ingot 1 and/or a clamping surface of the temperature-controlled clamp 2 by pumping and draining by a syringe pump/peristaltic pump and dripping onto the end surface of the ingot 1 and/or the clamping surface of the temperature-controlled clamp 2, by directly coating the end surface of the ingot 1 and/or the clamping surface of the temperature-controlled clamp 2 by spin coating/scraping/spraying/brushing/rolling/dipping, and/or transferring and coating the end surface of the ingot 1 and/or the clamping surface of the temperature-controlled clamp 2 by means of an adsorbent material, and further by forcing the water-soluble medium 3 to diffuse by applying pressure by the temperature-controlled clamp 2 and evenly distributing between the end surface of the ingot 1 and the clamping surface of the temperature-controlled clamp 2, or between the clamping surfaces of the pair of temperature-controlled clamps 2.

In addition, to facilitate the uniform diffusion of the water-soluble medium 3 by applying pressure through the temperature-controlled clamp 2 and to make the freezing performance of the water-soluble medium 3 suitable for cooling and solidification, before and after the cooling and solidification process, a pressure applied by the temperature-controlled clamp 2 to the water-soluble medium 3 during the cooling and solidification is controlled to be 1-3000 N, the cooling temperature is 1-40 °C lower than a freezing point of the water-soluble medium 3, the cooling time is 10-600 s, a use amount of the water-soluble medium 3 is controlled to be 0.1-20 mL, and a thickness of the water-soluble medium after the cooling and solidification is controlled to be 20-200 µm.

Finally, in the S2, the modified layer 12 of the ingot 1 may be easily separated by controlling a moving stretching speed of the temperature-controlled clamp 2 to be 0.01-5.00 mm/min.

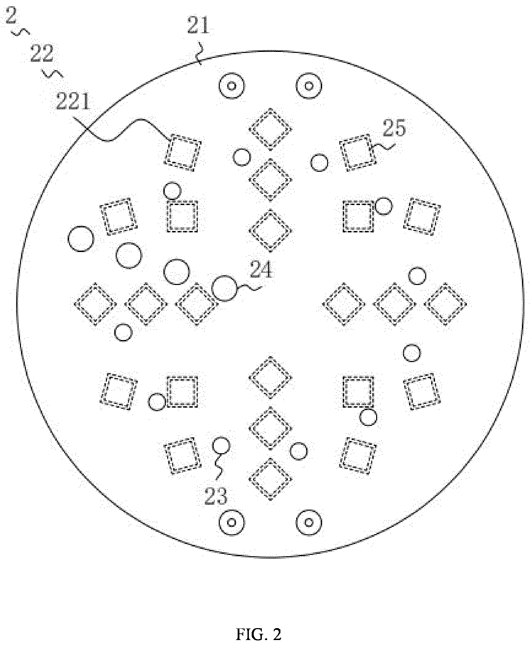

Example 2: referring to FIG. 1 and FIG. 2, disclosed is a cryo-peeling method for a wafer 11. A difference between this embodiment and Example 1 is that the temperature-controlled clamp 2 includes a heat-conducting clamp seat 21, a cooling and heating module 22 arranged on the heat-conducting clamp seat 21, a plurality of injection channels 23 formed on the heat-conducting clamp seat 21, and a plurality of temperature detection modules 24.

The cooling and heating module 22 performs cooling or heating by diffusing from a central area to a peripheral area of the heat-conducting clamp seat 21, and the diffusion path of the cooling and heating module 22 is one or a combination of a row-by-row diffusion path, a grid-interlaced diffusion path, a concentric circle diffusion path and a spiral line diffusion path.

These injection channels 23 may be arranged on one of the temperature-controlled clamps 2 or on two temperature-controlled clamps 2. In this embodiment, the injection channels are preferably arranged on the upper temperature-controlled clamp 2. A liquid inlet 222 of the injection channel 23 is used to receive the water-soluble medium 3, and a liquid outlet 223 is arranged on a clamping surface of the heat-conducting clamp seat 21. Specifically, the water-soluble medium 3 may be coated by dripping. That is, during coating, the clamping surfaces of the pair of temperature-controlled clamps 2 are in a state of being fitted up and down and arranged in a gap, and then the water-soluble medium is pumped by a syringe pump/peristaltic pump to flow into the liquid inlet 222 of the injection channel 23, and is dripped and coated on the clamping surface of the other heat-conducting clamp seat 21 through the liquid outlet 223 of the injection channel 23, and then the water-soluble medium 3 is forced to diffuse by applying pressure and is uniformly distributed between the clamping surfaces of the pair of temperature-controlled clamps 2.

The temperature detection modules 24 are mounted on the heat-conducting clamp seat 21 with the detection ends facing the clamping surface, and are arranged in sequence along the diffusion path of the cooling and heating module 22. The temperature detection modules 24 are temperature sensors. The temperature detection modules 24 are used to detect the temperature of each area from the central area to the peripheral area of the heat-conducting clamp seat 21, so as to control the temperature difference of the clamping surface of the temperature-controlled clamp 2 within ±2 °C. The temperature sensor may be, for example, a contact temperature sensor, preferably a PT100 temperature sensor, and the PT100 temperature sensor is in contact with the inside of the temperature-controlled clamp seat 2 through the heat-conducting silicone grease.

Example 3: referring to FIG. 2, disclosed is a cryo-peeling method for a wafer 11. A difference between this embodiment and Example 2 is that the diffusion path of the cooling and heating module 22 is a concentric circle diffusion path, and the cooling and heating module 22 includes a plurality of 10 mm*10 mm square thermoelectric coolers 221 arranged along the diffusion path, and the thermoelectric coolers 221 are horizontally and uniformly distributed on the heat-conducting clamp seat 21.

To improve the cooling effect, a water cooling block 25 is arranged at one side of the thermoelectric cooler far away from the clamping surface of the heat-conducting clamp seat 21 by conductive silver paste. The water-cooling block 25 is a metal block made of copper or aluminum with water channels inside. To ensure the heat dissipation effect, a single water-cooling block 25 is connected to a water-cooling machine by a liquid injection hole for cooling. This parallel connection method, compared with the series connection method of the water-cooling blocks 25, makes the water-cooling temperature of the thermoelectric cooler 221 tend to be consistent, thereby ensuring the cooling effect.

Example 4: disclosed is a cryo-peeling method for a wafer 11. A difference between this embodiment and Example 3 is that, to further improve the cooling effect of the thermoelectric cooler 221, two thermoelectric coolers 221 may be arranged in a stacked manner.

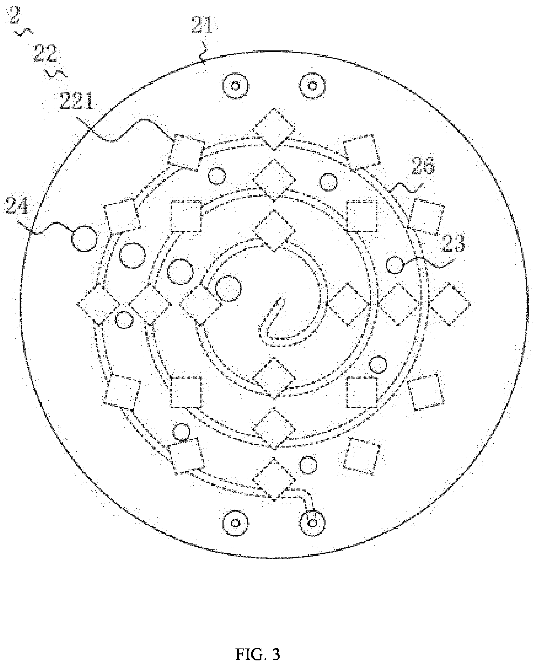

Example 5: referring to FIG. 3, disclosed is a cryo-peeling method for a wafer 11. A difference between this embodiment and Example 3 is that, to improve the cooling effect, a heat dissipation channel 26 is arranged at one side of the thermoelectric cooler 221 away from the clamping surface of the heat-conducting clamp seat 21 by heat-conducting silicone grease, and a flow path of a cooling medium in the heat dissipation channel 26 passes through these thermoelectric coolers 221 in sequence from the inside to the outside. The orthographic projection of the heat dissipation channel 26 on the clamping surface of the heat-conducting clamp seat 21 is in a spiral line shape, which ensures uniform heat dissipation of the thermoelectric cooler 221. The cooling medium of the heat dissipation channel 26 is cold air.

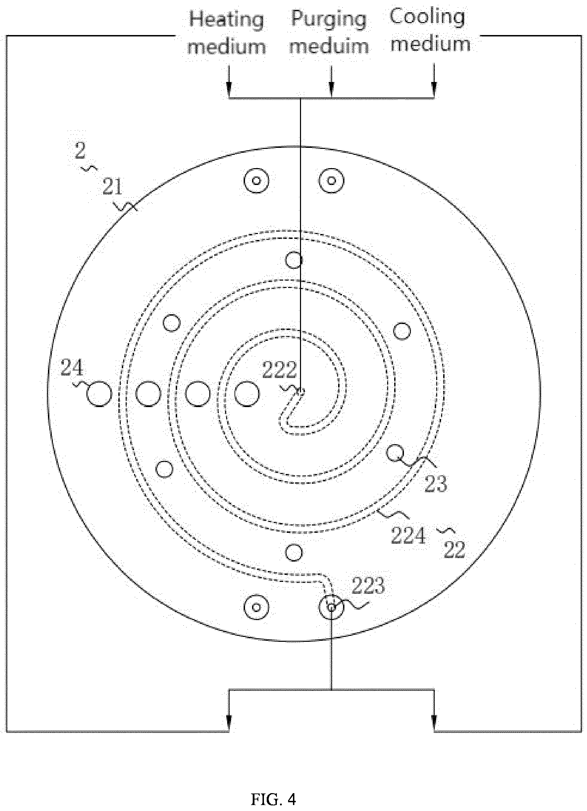

Example 6: referring to FIG. 4, disclosed is a cryo-peeling method for a wafer 11. A difference between this embodiment and Example 2 is that a diffusion path of the cooling and heating module 22 is a spiral line diffusion path, and the cooling and heating module 22 includes a liquid inlet 222 arranged near the center of the heat-conducting clamp seat 21, a liquid outlet 223 arranged near a periphery of the heat-conducting clamp seat 21, and a cold and hot medium channel 224 arranged between the liquid inlet 222 and the liquid outlet 223.

Correspondingly, the orthographic projection of the cold and hot medium channel 224 on the clamping surface of the heat-conducting clamp seat 21 is in a spiral line shape, the heating medium of the cold and hot medium channel 224 is hot air, the purging medium of the cold and hot medium channel 224 is compressed air, and the cooling medium of the cold and hot medium channel 224 is cold air.

Example 7: disclosed is a cryo-peeling method for a wafer 11. A difference between this embodiment and Example 3 is that: the cryo-peeling method for the wafer includes the following steps:
S1: 8 mL of a water-soluble medium 3 was dripped onto the surface of a pair of temperature-controlled clamps 2 by the injection channel 23, and the water-soluble medium 3 was water. The pair of temperature-controlled clamps 2 were separated, and the laser-modified 6-inch ingot 1 was mounted between the pair of temperature-controlled clamps 2. Then, the opposite pressure was continuously applied through the temperature-controlled clamp 2 to make the ingot 1 and the temperature-controlled clamp 2 completely contact through the water-soluble medium 3. The applied pressure was controlled to be 500 N, and the thermoelectric cooler 221 on the temperature-controlled clamps 2 was started. The water-soluble medium 3 was cooled and solidified for 600 s under the action of the temperature-controlled clamps 2, and was cooled to -10 °C. The thickness of the water-soluble medium 3 after cooling and solidification was 70-80 µm, and the bonding and fixing of the ingot 1 between the pair of temperature-controlled clamps 2 was completed.
S2: A reverse pulling force was applied to the pair of temperature-controlled clamps 2 to move the temperature-controlled clamps 2 at a tensile speed of 2 mm/min until a peeling force was 1784 N and the modified layer 12 of the ingot 1 was separated. After the peeling was completed, the thermoelectric cooler 221 of the temperature-controlled clamp 2 switched the heating and cooling working surfaces by the switching of a positive electrode and a negative electrode of a power supply, and the liquefied water-soluble medium 3 was heated to remove the peeled wafer 11 and the remaining ingot 13 from the temperature-controlled clamp 2. The removed wafer 11 was blown off by an air gun and subjected to the next process.

Example 8: disclosed is a cryo-peeling method for a wafer 11. A difference between this embodiment and Example 3 is that: the cryo-peeling method for the wafer includes the following steps:
S1: 12 mL of a water-soluble medium 3 was dripped onto the surface of a pair of temperature-controlled clamps 2 by the injection channel 23, and the water-soluble medium 3 was a 35 v/v% Tween aqueous solution. The pair of temperature-controlled clamps 2 were separated, and the laser-modified 6-inch ingot 1 was mounted between the pair of temperature-controlled clamps 2. Then, the opposite pressure was continuously applied through the temperature-controlled clamp 2 to make the ingot 1 and the temperature-controlled clamp 2 completely contact through the water-soluble medium 3. The applied pressure was controlled to be 50 N, and the thermoelectric cooler 221 on the temperature-controlled clamps 2 was started. The water-soluble medium 3 was cooled and solidified for 420 s under the action of the temperature-controlled clamps 2, and was cooled to -50 °C. The thickness of the water-soluble medium 3 after cooling and solidification was 100-120 µm, and the bonding and fixing of the ingot 1 between the pair of temperature-controlled clamps 2 was completed.
S2: A reverse pulling force was applied to the pair of temperature-controlled clamps 2 to move the temperature-controlled clamps 2 at a tensile speed of 5 mm/min until a peeling force was 2453 N and the modified layer 12 of the ingot 1 was separated. After the peeling was completed, the thermoelectric cooler 221 of the temperature-controlled clamp 2 switched the heating and cooling working surfaces by the switching of a positive electrode and a negative electrode of a power supply, and the liquefied water-soluble medium 3 was heated to remove the peeled wafer 11 and the remaining ingot 13 from the temperature-controlled clamp 2. The removed wafer 11 was blown off by an air gun and subjected to the next process.

Example 9: disclosed is a cryo-peeling method for a wafer 11. A difference between this embodiment and Example 5 is that: the cryo-peeling method for the wafer includes the following steps:
S1: 8 mL of a water-soluble medium 3 was dripped onto the surface of a pair of temperature-controlled clamps 2 by the injection channel 23, and the water-soluble medium 3 was a 35 v/v% Tween aqueous solution. The pair of temperature-controlled clamps 2 were separated, and the laser-modified 6-inch ingot 1 was mounted between the pair of temperature-controlled clamps 2. Then, the opposite pressure was continuously applied through the temperature-controlled clamp 2 to make the ingot 1 and the temperature-controlled clamp 2 completely contact through the water-soluble medium 3. The applied pressure was controlled to be 800 N, and the thermoelectric cooler 221 on the temperature-controlled clamps 2 was started. The water-soluble medium 3 was cooled and solidified for 120 s under the action of the temperature-controlled clamps 2, and was cooled to -10 °C. The thickness of the water-soluble medium 3 after cooling and solidification was 70-80 µm, and the bonding and fixing of the ingot 1 between the pair of temperature-controlled clamps 2 was completed.
S2: A reverse pulling force was applied to the pair of temperature-controlled clamps 2 to move the temperature-controlled clamps 2 at a tensile speed of 4 mm/min until a peeling force was 1867 N and the modified layer 12 of the ingot 1 was separated. After the peeling was completed, the thermoelectric cooler 221 of the temperature-controlled clamp 2 switched the heating and cooling working surfaces by the switching of a positive electrode and a negative electrode of a power supply, and the liquefied water-soluble medium 3 was heated to remove the peeled wafer 11 and the remaining ingot 13 from the temperature-controlled clamp 2. The removed wafer 11 was blown off by an air gun and subjected to the next process.

Example 10: disclosed is a cryo-peeling method for a wafer 11. A difference between this embodiment and Example 6 is that: the cryo-peeling method for the wafer includes the following steps:
S1: 20 mL of a water-soluble medium 3 was dripped onto the surface of a pair of temperature-controlled clamps 2 by the injection channel 23, and the water-soluble medium 3 was a 35 v/v% Tween aqueous solution. The pair of temperature-controlled clamps 2 were separated, and the laser-modified 6-inch ingot 1 was mounted between the pair of temperature-controlled clamps 2. Then, the opposite pressure was continuously applied through the temperature-controlled clamp 2 to make the ingot 1 and the temperature-controlled clamp 2 completely contact through the water-soluble medium 3. The applied pressure was controlled to be 300 N, and the thermoelectric cooler 221 on the temperature-controlled clamps 2 was started. The water-soluble medium 3 was cooled and solidified for 60 s under the action of the temperature-controlled clamps 2, and was cooled to -100 °C. The thickness of the water-soluble medium 3 after cooling and solidification was 180-200 µm, and the bonding and fixing of the ingot 1 between the pair of temperature-controlled clamps 2 was completed.
S2: A reverse pulling force was applied to the pair of temperature-controlled clamps 2 to move the temperature-controlled clamps 2 at a tensile speed of 0.1 mm/min until a peeling force was 2334 N and the modified layer 12 of the ingot 1 was separated. After the peeling was completed, the thermoelectric cooler 221 of the temperature-controlled clamp 2 switched the heating and cooling working surfaces by the switching of a positive electrode and a negative electrode of a power supply, and the liquefied water-soluble medium 3 was heated to remove the peeled wafer 11 and the remaining ingot 13 from the temperature-controlled clamp 2. The removed wafer 11 was blown off by an air gun and subjected to the next process.

Example 11: disclosed is a cryo-peeling method for a wafer 11. A difference between this embodiment and Example 3 is that: the cryo-peeling method for the wafer includes the following steps:
S1: 8 mL of a water-soluble medium 3 was dripped onto the surface of a pair of temperature-controlled clamps 2 by the injection channel 23, and the water-soluble medium 3 is a 5 v/v% aqueous solution of a silane coupling agent. The pair of temperature-controlled clamps 2 were separated, and the laser-modified 6-inch ingot 1 was mounted between the pair of temperature-controlled clamps 2. Then, the opposite pressure was continuously applied through the temperature-controlled clamp 2 to make the ingot 1 and the temperature-controlled clamp 2 completely contact through the water-soluble medium 3. The applied pressure was controlled to be 500 N, and the thermoelectric cooler 221 on the temperature-controlled clamps 2 was started. The water-soluble medium 3 was cooled and solidified for 600 s under the action of the temperature-controlled clamps 2, and was cooled to -10 °C. The thickness of the water-soluble medium 3 after cooling and solidification was 70-80 µm, and the bonding and fixing of the ingot 1 between the pair of temperature-controlled clamps 2 was completed.
S2: A reverse pulling force was applied to the pair of temperature-controlled clamps 2 to move the temperature-controlled clamps 2 at a tensile speed of 2 mm/min until a peeling force was N and the modified layer 12 of the ingot 1 was separated. After the peeling was completed, the thermoelectric cooler 221 of the temperature-controlled clamp 2 switched the heating and cooling working surfaces by the switching of a positive electrode and a negative electrode of a power supply, and the liquefied water-soluble medium 3 was heated to remove the peeled wafer 11 and the remaining ingot 13 from the temperature-controlled clamp 2. The removed wafer 11 was blown off by an air gun and subjected to the next process.

Example 12: disclosed is a cryo-peeling method for a wafer 11. A difference between this embodiment and Example 3 is that: the cryo-peeling method for the wafer includes the following steps:
S1: 8 mL of a water-soluble medium 3 was dripped onto the surface of a pair of temperature-controlled clamps 2 by the injection channel 23, and the water-soluble medium 3 is a 5 v/v% aqueous solution of polyacrylamide anions. The pair of temperature-controlled clamps 2 were separated, and the laser-modified 6-inch ingot 1 was mounted between the pair of temperature-controlled clamps 2. Then, the opposite pressure was continuously applied through the temperature-controlled clamp 2 to make the ingot 1 and the temperature-controlled clamp 2 completely contact through the water-soluble medium 3. The applied pressure was controlled to be 500 N, and the thermoelectric cooler 221 on the temperature-controlled clamps 2 was started. The water-soluble medium 3 was cooled and solidified for 600 s under the action of the temperature-controlled clamps 2, and was cooled to -10 °C. The thickness of the water-soluble medium 3 after cooling and solidification was 70-80 µm, and the bonding and fixing of the ingot 1 between the pair of temperature-controlled clamps 2 was completed.
S2: A reverse pulling force was applied to the pair of temperature-controlled clamps 2 to move the temperature-controlled clamps 2 at a tensile speed of 2 mm/min until the modified layer 12 of the ingot 1 was separated. After the peeling was completed, the thermoelectric cooler 221 of the temperature-controlled clamp 2 switched the heating and cooling working surfaces by the switching of a positive electrode and a negative electrode of a power supply, and the liquefied water-soluble medium 3 was heated to remove the peeled wafer 11 and the remaining ingot 13 from the temperature-controlled clamp 2. The removed wafer 11 was blown off by an air gun and subjected to the next process.

Example 13: disclosed is a cryo-peeling method for a wafer 11. A difference between this embodiment and Example 3 is that: the cryo-peeling method for the wafer includes the following steps:
S1: 8 mL of a water-soluble medium 3 was dripped onto the surface of a pair of temperature-controlled clamps 2 by the injection channel 23, and the water-soluble medium 3 is a 5 v/v% aqueous solution of polyacrylamide anions. The pair of temperature-controlled clamps 2 were separated, and the laser-modified 6-inch ingot 1 was mounted between the pair of temperature-controlled clamps 2. Then, the opposite pressure was continuously applied through the temperature-controlled clamp 2 to make the ingot 1 and the temperature-controlled clamp 2 completely contact through the water-soluble medium 3. The applied pressure was controlled to be 500 N, and the thermoelectric cooler 221 on the temperature-controlled clamps 2 was started. The water-soluble medium 3 was cooled and solidified for 600 s under the action of the temperature-controlled clamps 2, and was cooled to -10 °C. The thickness of the water-soluble medium 3 after cooling and solidification was 70-80 µm, and the bonding and fixing of the ingot 1 between the pair of temperature-controlled clamps 2 was completed.
S2: A reverse pulling force was applied to the pair of temperature-controlled clamps 2 to move the temperature-controlled clamps 2 at a tensile speed of 2 mm/min until the modified layer 12 of the ingot 1 was separated. After the peeling was completed, the thermoelectric cooler 221 of the temperature-controlled clamp 2 switched the heating and cooling working surfaces by the switching of a positive electrode and a negative electrode of a power supply, and the liquefied water-soluble medium 3 was heated to remove the peeled wafer 11 and the remaining ingot 13 from the temperature-controlled clamp 2. The removed wafer 11 was blown off by an air gun and subjected to the next process.

Example 14: disclosed is a cryo-peeling method for a wafer 11. A difference between this embodiment and Example 3 is that: the cryo-peeling method for the wafer includes the following steps:
S1: 8 mL of a water-soluble medium 3 was dripped onto the surface of a pair of temperature-controlled clamps 2 by the injection channel 23, and the water-soluble medium 3 is a 5 v/v% aqueous solution of carboxymethyl cellulose. The pair of temperature-controlled clamps 2 were separated, and the laser-modified 6-inch ingot 1 was mounted between the pair of temperature-controlled clamps 2. Then, the opposite pressure was continuously applied through the temperature-controlled clamp 2 to make the ingot 1 and the temperature-controlled clamp 2 completely contact through the water-soluble medium 3. The applied pressure was controlled to be 500 N, and the thermoelectric cooler 221 on the temperature-controlled clamps 2 was started. The water-soluble medium 3 was cooled and solidified for 600 s under the action of the temperature-controlled clamps 2, and was cooled to -10 °C. The thickness of the water-soluble medium 3 after cooling and solidification was 70-80 µm, and the bonding and fixing of the ingot 1 between the pair of temperature-controlled clamps 2 was completed.
S2: A reverse pulling force was applied to the pair of temperature-controlled clamps 2 to move the temperature-controlled clamps 2 at a tensile speed of 2 mm/min until the modified layer 12 of the ingot 1 was separated. After the peeling was completed, the thermoelectric cooler 221 of the temperature-controlled clamp 2 switched the heating and cooling working surfaces by the switching of a positive electrode and a negative electrode of a power supply, and the liquefied water-soluble medium 3 was heated to remove the peeled wafer 11 and the remaining ingot 13 from the temperature-controlled clamp 2. The removed wafer 11 was blown off by an air gun and subjected to the next process.

### Comparative Example

Comparative Example 1: disclosed is a cryo-peeling method for a wafer. A difference between this example and Example 4 is that a thermoplastic glue is used instead of a water-soluble medium solution.

Comparative Example 2: disclosed is a cryo-peeling method for a wafer. A difference between this example and Example 4 is that paraffin is used instead of a water-soluble medium solution.

Comparative Example 3: disclosed is a cryo-peeling method for a wafer. A difference between this example and Example 4 is that vacuum suction cups for stretching and peeling are used instead of temperature-controlled clamps and water-soluble medium solution for stretching and peeling.

Comparative Example 4: disclosed is a cryo-peeling method for a wafer. A difference between this example and Example 4 is that a water-soluble medium solution is used to infiltrate the modified layer and then subjected to freeze-expansion separation is used instead of temperature-controlled clamps and water-soluble medium solution for stretching and peeling.

### Performance testing

(1) The peeled wafers obtained from Example 4 and Comparative Examples 1 to 4 were tested for bonding time, peeling force, wafer integrity, cleaning method, and cleaning time. The test results are shown in Table 1.

**Table 1**

| | Peeling method | Bonding time | Peel force | Wafer integrity | Cleaning method | Cleaning time |
|---|---|---|---|---|---|---|
| Example 7 | Water-ice bonding | 2 min | 3619 N | Yes | Air gun blow-off | 10s |
| Comparative Example 1 | Adhesive peeling | 15 min | 3875 N | Yes | Glue dissolving agent | 1 h+ |
| Comparative Example 2 | Wax peeling | 5 min | 3156 N | No | Anhydrous ethanol | 5 min |
| Comparative Example 3 | Suction cup adsorption | 5 s | 1384 N | Unseparated | - | - |
| Comparative Example 4 | Liquid expansion | 5 min | - | No | Washing by water | 10 s |

It can be seen from Table 1 that the bonding force of the water-ice bonding may also reach a peeling force close to that of the adhesive bonding and wax bonding, and the peeling efficiency is higher and the cleaning is relatively convenient; while the peeling force of the vacuum suction cup is limited and is not enough to successfully peel off the wafer, and although the freeze-expansion is more convenient, it is prone to fragmentation.
(2) The methods of Examples 7 and 11 to 14 were used to test the pull-off force of a 6-inch wafer after freezing with different water-soluble medium solutions at different temperatures. The test results are shown in Table 2.

**Table 2**

| | Pulling-off force (N) at -40 °C | Pulling-off force (N) at -30 °C | Pulling-off force (N) at -20 °C | Pulling-off force (N) at -10 °C |
|---|---|---|---|---|
| Example 7 | 6183 | 4561 | 2573 | 1784 |
| Example 11 | 13074 | 10245 | 8468 | 4541 |
| Example 12 | 11971 | 9283 | 6234 | 3538 |
| Example 13 | 4752 | 3248 | 2357 | 1145 |
| Example 14 | 8051 | 6776 | 5433 | 3143 |

It can be seen from Table 2 that as a cooling temperature of a refrigerant decreases, the bonding force is significantly enhanced. In addition, the bonding force between the clamp and the wafer may be significantly improved by activating and modifying the aqueous solution. The addition of silane coupling agent has increased the bonding force with the polyacrylamide anion aqueous solution to the maximum.

Finally, it should be noted that the above embodiments are only used to illustrate the technical solution of the present invention and are not intended to limit the present invention. Although the present invention has been described in detail with reference to the preferred embodiments, those skilled in the art should understand that the technical solution of the present invention may be modified or replaced by equivalents without departing from the purpose and scope of the technical solution of the present invention, which should be included in the scope of the claims of the present invention.

## Claims

1. A wafer cryo-peeling method, comprising the following steps:
S1. coating a liquid water-soluble medium on an end surface of an ingot and/or a clamping surface of a temperature-controlled clamp, and cooling and solidifying the water-soluble medium under the action of the temperature-controlled clamp to complete fixing of the ingot between a pair of temperature-controlled clamps; and
S2. moving at least one temperature-controlled clamp until a modified layer of the ingot is separated, and after peeling is completed, heating and liquefying the solid water-soluble medium under the action of the temperature-controlled clamp to obtain a wafer and remaining ingot.

2. The wafer cryo-peeling method according to claim 1, wherein in the S1, the water-soluble medium is one or a combination of water, a water-soluble organic compound, and a water-soluble inorganic compound.

3. The wafer cryo-peeling method according to claim 2, wherein in the S1, a freezing point of the water-soluble medium is -50 °C to 80 °C, and a dynamic viscosity at room temperature and atmospheric pressure is 1.01×10⁻³-100 Pa·s.

4. The wafer cryo-peeling method according to claim 2, wherein in the S1, a volume concentration of each water-soluble organic compound and each water-soluble inorganic compound in the combination is 0.5-35% independently in the combination of water, a water-soluble organic compound and/or a water-soluble inorganic compound.

5. The wafer cryo-peeling method according to claim 2, wherein in the S1, the water-soluble medium is one or a combination of water, a silane coupling agent, anionic polyacrylamide, cationic polyacrylamide, carboxymethyl cellulose and a surfactant.

6. The wafer cryo-peeling method according to claim 1, wherein in the S1, a pressure applied by the temperature-controlled clamp to the water-soluble medium during the cooling and solidification is controlled to be 1-3000 N, the cooling temperature is 1-40 °C lower than a freezing point of the water-soluble medium, the cooling time is 10-600 s, a use amount of the water-soluble medium is controlled to be 0.1-20 mL, and a thickness of the water-soluble medium after the cooling and solidification is controlled to be 20-200 µm.

7. The wafer cryo-peeling method according to claim 1, wherein in the S1, the water-soluble medium is coated by dripping, spin coating, scraping, spraying, brushing, rolling, dipping, and transferring with an absorbent material having the water-soluble medium absorbed thereon.

8. The wafer cryo-peeling method according to claim 1, wherein in the S2, a moving stretching speed of the temperature-controlled clamp is controlled to be 0.01-5.00 mm/min.

9. The wafer cryo-peeling method according to claim 1, wherein the temperature-controlled clamp comprises a heat-conducting clamp seat, a cooling and heating module arranged on the heat-conducting clamp seat, and a plurality of temperature detection modules, the cooling and heating module performs cooling or heating by diffusing from a central area to a peripheral area of the heat-conducting clamp seat, and the temperature detection modules are mounted on the heat-conducting clamp seat with detection ends facing a clamping surface and are arranged sequentially along a diffusion path of the cooling and heating module.

10. The wafer cryo-peeling method according to claim 9, wherein the diffusion path of the cooling and heating module is one or a combination of a row-by-row diffusion path, a grid-interlaced diffusion path, a concentric circle diffusion path and a spiral line diffusion path.
